# EUROPEAN PATENT APPLICATION

(11) **EP 1 933 372 A1**
(43) Date of publication of application: **18.06.2008**
(21) Application number: 06796563.2
(22) Date of filing: 21.08.2006
(51) Int. Cl.: H01L 21/205, C23C 16/56, C30B 23/00

(54) **PROCESS FOR PRODUCING EPITAXIAL WAFER AND EPITAXIAL WAFER PRODUCED THEREFROM**

(30) Priority: 12.09.2005 JP 2005264000
(71) Applicant: Shin-Etsu Handotai Co., Ltd., Tokyo 100-0004 (JP)
(72) Inventor: YOSHIDA, Tomosuke, Annaka-shi, Gunma, 379-0196 (JP); TODA, Naohisa, Annaka-shi, Gunma, 379-0196 (JP)
(74) Representative: Wibbelmann, Jobst
(86) International application number: PCT/JP2006/316300
(87) International publication number: WO 2007/032180

(57) **Abstract**

In a vapor phase growth apparatus, epitaxial growth is performed with respect to a wafer having a CVD film formed on a back surface thereof as a wafer for monitoring that is used to guarantee a resistance and/or measure a thickness of an epitaxial layer, then epitaxial growth is performed with respect to a wafer as a dummy or a vapor phase growth apparatus is activated under conditions for performing epitaxial growth without using a wafer, and subsequently epitaxial growth is carried out with respect to a wafer as a product, thereby manufacturing an epitaxial wafer. As a result, when using a wafer having no CVD film to manufacture an epitaxial wafer that is used to fabricate an imaging device, e.g., a CCD or a CMOS image sensor, a method capable of effectively avoiding heavy-metal contamination and manufacturing a high-quality epitaxial layer is provided.

## Description

### TECHNICAL FIELD

The present invention relates to a method for manufacturing an epitaxial wafer, and more particularly to a method for manufacturing an epitaxial wafer for an imaging device such as a CCD or a CMOS image sensor without occurring heavy-metal contamination.

### BACKGROUND ART

When manufacturing a semiconductor device, an epitaxial wafer having a single-crystal thin film grown on a semiconductor wafer, e.g., a silicon wafer is used in some cases. The epitaxial wafer can be manufactured by, e.g., a vapor phase epitaxial growth technology. The vapor phase epitaxial growth technology is a technology that subjects a single-crystal thin film layer used for manufacture of an integrated circuit to vapor phase growth, and it is a very important technology that can grow a uniform single-crystal thin film on a clean semiconductor single crystal substrate (semiconductor wafer) in accordance with a crystal orientation of the substrate or form a precipitous impurity concentration gradient of a junction having a large dopant concentration difference.

In recent years, achieving uniformity in a plane of a film thickness or a resistivity of a silicon single crystal thin film (epitaxial layer) to be formed is important while a reduction in film thickness or an increase in a diameter of a wafer advances with miniaturization of a device. As an apparatus that performs vapor phase epitaxial growth (vapor phase growth apparatus), three types, i.e., a vertical type (pancake type), a barrel type (cylinder type), and a horizontal type are generally known, and a single-wafer processing type apparatus that can relatively easily control, e.g., a film thickness distribution is becoming a mainstream in place of an apparatus that performs batch processing with respect to a plurality of wafers in manufacture of a silicon epitaxial wafer having a diameter of, e.g., 200 mm or above.

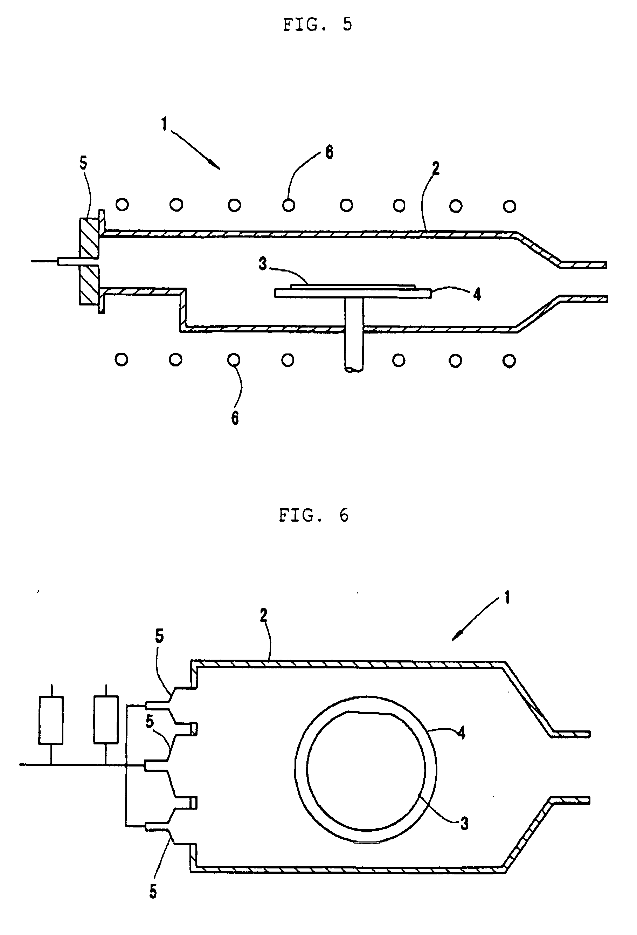

FIGS. 5 and 6 show an example of a single-wafer processing type vapor phase growth apparatus. This vapor phase growth apparatus 1 includes a quartz chamber 2, gas supplying means (injector) 5, substrate heating means 6, an others. A susceptor 4 that holds a wafer 3 is provided in the quartz chamber 2. The susceptor 4 can be rotated by a motor (not shown).
In such a single-wafer processing type apparatus 1, one silicon wafer 3 is horizontally held by the susceptor 4 in the chamber 2, a raw material gas is horizontally supplied in one direction through the injector 5, and a thin film can be subjected to vapor phase growth on the wafer 3 by heating using the heating means 6 e.g. halogen lamp.

When manufacturing an epitaxial wafer in this manner, a wafer for monitoring is generally performed epitaxial growth to guarantee a resistance or measure a thickness of an epitaxial layer to be formed before manufacturing an epitaxial wafer as a product, and then a wafer as a product is used to manufacture the epitaxial wafer.
Further, when a silicon wafer having a low resistance, i.e., a high dopant concentration is used to perform epitaxial growth, a phenomenon that a dopant in the wafer once jumps into a vapor phase and is again taken into an epitaxial growth layer during epitaxial growth, which is so-called auto-doping occurs. To avoid auto-doping, a wafer having a CVD oxide film formed on a back surface thereof is generally used to perform epitaxial growth.

On the other hand, although an epitaxial wafer is extensively used for an imaging device such as a CCD or a CMOS image sensor, a wafer having a high resistance, i.e., a low dopant concentration is used when manufacturing an epitaxial wafer for these imaging devices. When using a wafer having a high resistance to perform epitaxial growth in this manner, epitaxial growth can be performed without forming a CVD film to avoid auto-doping.

As the most important failure matter when fabricating these imaging devices, there is a white spot or a white nebulosity (white damage). Although a main factor of the white spot or the white nebulosity is a surface defect of an epitaxial layer, since the surface defect of the epitaxial layer is very sensitively affected by a heavy-metal contamination level of a substrate material (wafer), a reduction in a heavy metal is very important.
As a measure for reducing a heavy metal, there are an improvement in a purity of each constituent member of a vapor phase growth apparatus, an increase in a purity of a raw material (e.g., a gas or an Si substrate), prevention of contamination in maintenance of a chamber, and others.

Furthermore, it is known that presence of moisture greatly affects heavy-metal contamination, and an apparatus that measures moisture in a reactive gas or a chamber has been proposed (see Japanese Patent Application Laid-open No. 2001-244200, Japanese Patent Application Laid-open No. 2001-244201, and Japanese Patent Application Laid-open No. 2001-244202).
Moreover, when using a wafer having a CVD oxide film formed on a back surface thereof to perform epitaxial growth, since moisture may be discharged from the CVD oxide film to adversely affect an epitaxial layer, a method of reducing a moisture concentration in the CVD oxide film by a heat treatment and forming an epitaxial layer on a front surface of this wafer to manufacture an epitaxial wafer has been proposed (see Japanese Patent Application Laid-open No. 2002-164286).

On the other hand, when manufacturing an epitaxial wafer for an imaging device, e.g., a CCD or a CMOS image sensor, even though a wafer having no CVD film is used to perform epitaxial growth, a surface defect of an epitaxial layer may occur in some cases.

### DISCLOSURE OF THE INVENTION

It is a main object of the present invention to provide a method capable of effectively avoiding heavy-metal contamination and manufacturing a high-quality epitaxial wafer when using a wafer having no CVD film to manufacture an epitaxial wafer that is used to fabricate an imaging device, e.g., a CCD or a CMOS image sensor.

According to the present invention, there is provided a method for manufacturing an epitaxial wafer, comprising: performing epitaxial growth with respect to a wafer having a CVD film formed on a back surface thereof as a wafer for monitoring that is used to guarantee a resistance and/or measure a thickness of an epitaxial layer in a vapor phase growth apparatus; performing epitaxial growth with respect to a wafer as a dummy or activating the vapor phase growth apparatus under conditions for performing epitaxial growth without using a wafer; and then carrying out epitaxial growth with respect to a wafer as a product to manufacture the epitaxial wafer.

As will be explained later, it was revealed that, when the wafer having the CVD film formed on the back surface thereof is used as the wafer for monitoring to perform epitaxial growth, moisture discharged from the CVD film remains in a chamber and this becomes a factor of heavy-metal contamination in subsequent manufacture of the epitaxial wafer. Thus, after performing epitaxial growth with respect to the wafer for monitoring having the CVD film formed on the back surface thereof, when epitaxial growth is performed with respect to the wafer as a dummy or the vapor phase growth apparatus is activated under conditions for performing epitaxial growth without using a wafer before carrying out epitaxial growth with respect to the wafer as a product, the heavy-metal contamination caused due to the moisture discharged from the CVD film of the wafer for monitoring is absorbed in the wafer as a dummy or a semiconductor layer formed on a susceptor and a peripheral member in the apparatus. Therefore, the heavy-metal contamination with respect to the wafer as a product is then reduced, thereby manufacturing the high-quality epitaxial wafer.

Additionally, there is provided a method for manufacturing an epitaxial wafer, comprising: preparing a wafer in which a CVD film is formed on a back surface thereof and moisture is then removed from the CVD film by subjecting to a heat treatment as a wafer for monitoring that is used to guarantee a resistance and/or measure a thickness of an epitaxial layer; performing epitaxial growth with respect to the prepared wafer for monitoring in a vapor phase growth apparatus; and then carrying out epitaxial growth with respect to a wafer as a product to manufacture the epitaxial wafer.

After forming the CVD film on the back surface, when epitaxial growth is performed with respect to the wafer for monitoring from which moisture in the CVD film has been removed by subjecting to the heat treatment, the moisture is rarely discharged from the CVD film during epitaxial growth, and hence the heavy-metal contamination due to remaining moisture does not occur even if epitaxial growth is subsequently carried out with respect to the wafer as a product, thereby manufacturing the high-quality epitaxial wafer.

In this case, a silicon wafer having a silicon oxide film, a silicon nitride film, or a polysilicon film as the CVD film of the wafer for monitoring can be used.
As a substrate that becomes a material of the epitaxial wafer, a silicon wafer is most frequently used, and when a silicon wafer having a silicon oxide film, a silicon nitride film, or a polysilicon film that is the CVD film on the back surface is used as the wafer for monitoring, this serves as substantially the same wafer as the wafer as a product, which is particularly effective.

Further, there is provided a method for manufacturing an epitaxial wafer, comprising: performing epitaxial growth with respect to a wafer having no CVD film formed on a back surface thereof as a wafer for monitoring that is used to measure a thickness of an epitaxial layer in a vapor phase growth apparatus; and performing epitaxial growth with respect to a wafer as a product to manufacture the epitaxial wafer.

When epitaxial wafer is performed with respect to the wafer for monitoring having no CVD film formed on the back surface thereof to measure a thickness of the epitaxial layer, moisture is not discharged from the CVD film. Therefore, even if epitaxial growth is subsequently performed with respect to the wafer as a product, heavy-metal contamination does not occur, thus manufacturing the high-quality epitaxial wafer.

Furthermore, according to the present invention, there is provided a method for manufacturing an epitaxial wafer, comprising, when stopping heating to interrupt manufacture of the epitaxial wafer and then again subjecting to heating to restart manufacture in a vapor phase growth apparatus: performing epitaxial growth with respect to a wafer as a dummy or activating the vapor phase growth apparatus under conditions for performing epitaxial growth without using a wafer; and then carrying out epitaxial growth with respect to a wafer as a product to manufacture the epitaxial wafer.

As will be explained later, it was revealed that, when heating of the vapor phase growth apparatus is stopped and then heating is again performed to restart manufacture of the epitaxial wafer, the epitaxial wafer manufactured after restart is apt to be contaminated with a heavy metal due to moisture agglomerated in a chamber after stopping heating. Thus, at the time of restarting manufacture, after performing epitaxial growth with respect to the wafer as a dummy, or after activating the vapor phase growth apparatus under conditions for performing epitaxial growth without using a wafer, carrying out epitaxial growth with respect to the wafer as a product enables avoiding the heavy-metal contamination, thus manufacturing the high-quality epitaxial wafer.

It is preferable that a single-wafer processing type is used as the vapor phase growth apparatus.
In the single-wafer processing type vapor phase growth apparatus, a film thickness distribution and others can be readily controlled as compared with a batch type apparatus, thereby manufacturing a higher-quality epitaxial wafer.

It is preferable that, when performing epitaxial growth with respect to the wafer as a dummy or the wafer for monitoring or when activating the vapor phase growth apparatus under conditions for performing epitaxial growth without using a wafer, the number of times of performing each of these operations is two or below.
When the number of times of performing epitaxial growth with respect to the wafer as a dummy or the wafer for monitoring or the number of times of activating the vapor phase growth apparatus under conditions for performing epitaxial growth without using a wafer is set to two or below, an increase in a cost or a reduction in productivity can be suppressed, and the grown epitaxial layer can absorb the heavy-metal contamination caused due to the moisture in the chamber. Moreover, when using the wafer for monitoring, a resistance of the epitaxial layer can be assuredly guaranteed or a thickness of the same can be assuredly measured.

The epitaxial wafer as a product can be used for a CCD or a CMOS image sensor.
When manufacturing the epitaxial wafer for a CCD or a CMOS image sensor, since epitaxial growth is carried out with respect to the wafer for monitoring having an anti-auto-doping CVD film formed on the back surface thereof and then epitaxial growth is performed with respect to the wafer as a product having a high resistance and having no CVD film formed on the back surface thereof, the present invention becomes particularly effective.

Additionally, according to the present invention, an epitaxial wafer manufactured by the above-explained method is provided. The epitaxial wafer manufactured by the present invention becomes a high-quality epitaxial wafer in which heavy-metal contamination due to moisture is avoided or reduced.

According to the present invention, for example, in case of using the wafer having no CVD film formed on the back surface thereof to manufacture the epitaxial wafer for an imaging device, e.g., a CCD or a CMOS image sensor, when epitaxial growth is performed with respect to the wafer as a dummy or the vapor phase growth apparatus is activated under conditions for performing epitaxial growth without using a wafer after performing epitaxial growth with respect to the wafer for monitoring having the CVD film formed on the back surface thereof and before carrying out epitaxial growth with respect to the wafer as a product, heavy-metal contamination caused due to moisture discharged from the CVD layer of the wafer for monitoring is absorbed into the epitaxial layer formed on the wafer as a dummy or the semiconductor layer formed on, e.g., a susceptor in the apparatus, and a subsequent adverse impact on the wafer as a product can be avoided. Therefore, the high-quality epitaxial wafer that can be preferably used for an imaging device, e.g., a CCD or a CMOS image sensor can be manufactured.

### BRIEF DESCRIPTION OF THE DRAWINGS

FIG. 1 is a flowchart showing a first embodiment of an epitaxial wafer manufacturing process according to the present invention;
FIG. 2 is a flowchart showing a second embodiment of the epitaxial wafer manufacturing process according to the present invention;
FIG. 3 is a flowchart showing a third embodiment of the epitaxial wafer manufacturing process according to the present invention;
FIG. 4 is a flowchart showing a forth embodiment of the epitaxial wafer manufacturing process according to the present invention;
FIG. 5 is a schematic cross-sectional view showing an example of a single-wafer processing type vapor phase growth apparatus;
FIG. 6 is a schematic plan view showing an example of the single-wafer processing type vapor phase growth apparatus;
FIG. 7 is a graph showing a relationship between the number of wafers and a surface layer PL intensity in Example 1; and
FIG. 8 is a graph showing a relationship between the number of wafers and a surface layer PL intensity in Example 2.

### BEST MODE(S) FOR CARRYING OUT THE INVENTION

The present invention will now be specifically explained hereinafter.
The present inventors have keenly examined a factor of heavy-metal contamination of an epitaxial wafer. When manufacturing an epitaxial wafer used to fabricate an imaging device, e.g., a CCD or a CMOS image sensor, although a wafer having a high resistance, i.e., a low dopant concentration and having no CVD film for avoiding auto-doping formed on a back surface thereof is used to perform epitaxial growth, a wafer for monitoring is utilized to perform epitaxial growth before using a wafer as a product to perform epitaxial growth. Since a resistance or a thickness of an epitaxial layer can be highly accurately measured by an electrical evaluation method, a wafer having a low resistance, i.e., a high dopant concentration and having a CVD film formed on a back surface thereof is used as the wafer for monitoring and a high-resistance epitaxial layer is formed on this wafer.

However, it was revealed that, when epitaxial growth is performed with respect to the wafer for monitoring having the CVD film formed on the back surface thereof and then epitaxial growth is carried out by using the wafer as a product in order to guarantee a resistance or measure a thickness, a heavy-metal level is degraded even though the CVD film is not formed on the back surface of the wafer as a product. It can be considered that moisture discharged from the CVD film on the back surface of the wafer for monitoring remains to provoke heavy-metal contamination.

Further, it was also discovered that, in case of interrupting manufacture of the epitaxial wafer when, e.g., stopping a manufacturing line or adjusting the apparatus, the vapor phase growth apparatus stops supply of a gas and also stops heating, but a heavy-metal level of the wafer as a product is also degraded immediately after again performing heating to restart manufacture. It can be considered that moisture slightly contained in a carrier gas or moisture present in a reactor vessel is agglomerated upon stopping heating and, when manufacture is restarted, heavy-metal contamination occurs with respect to the wafer immediately after restart.

Thus, as a result of repeating keen examination about a method for avoiding the heavy-metal contamination, the present inventors have discovered various kinds of methods for effectively avoiding the heavy-metal contamination, thereby bringing the present invention to completion.
Although examples of using an N-type high-resistance (1 Ωcm or above) silicon wafer to manufacture an epitaxial wafer for an imaging device, e.g., a CCD or a CMOS sensor will be explained as preferred embodiments according to the present invention with reference to the accompanying drawings, the present invention is not restricted thereto.

### <First Embodiment>

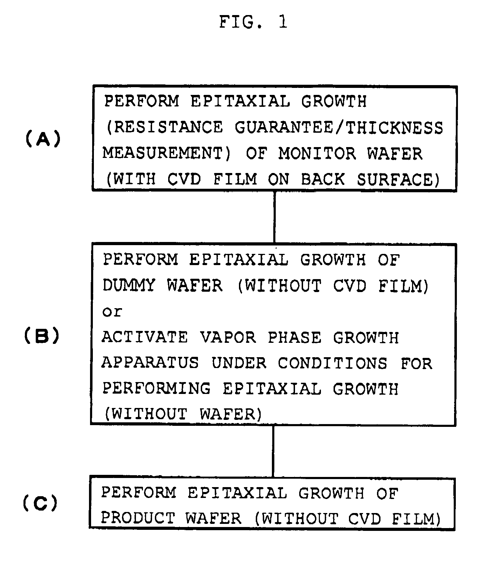

FIG. 1 is a flowchart showing a first embodiment of a method for manufacturing an epitaxial wafer according to the present invention.
First, in a vapor phase growth apparatus used for manufacture of an epitaxial wafer, epitaxial growth is performed with respect to a wafer for monitoring (monitor wafer) to guarantee a resistance of an epitaxial layer to be formed or measure a thickness of the same (FIG. 1(A)).
It is to be noted that the vapor phase growth apparatus to be used is not restricted to a specific type in particular, and both a batch type and a single-wafer processing type can be used, but utilizing such a single-wafer processing type apparatus as shown in FIG. 5 enables readily controlling, e.g., a film thickness distribution as compared with the batch type apparatus, which is preferable.

As the monitor wafer, a wafer having properties similar to those of a wafer as a product (product wafer) as far as possible is used. However, since a resistance or a thickness of an epitaxial layer can be highly accurately measured based on an electrical difference between the monitor wafer and the epitaxial layer formed thereon, an N-type silicon wafer having a low resistance, i.e., a high dopant concentration and having a CVD film for avoiding auto-doping formed on a back surface thereof is used as the monitor wafer, and a high-resistance epitaxial layer is formed on a front surface of this silicon wafer. (When the product wafer is of a P type, the monitor is also of the P type) .

It is to be noted that, as the CVD film on the back surface, for example, a silicon oxide film, a silicon nitride film, or a polysilicon film is preferable. These CVD films can be readily formed, and can assuredly avoid auto-doping during epitaxial growth, and do not contaminate the wafer or the epitaxial layer.

The number of times of performing epitaxial growth with respect to the monitor wafer is not restricted in particular, and epitaxial growth may be performed twice to guarantee a resistance and measure a thickness. It is to be noted that a wafer having a high resistance is used as the wafer as a product whereas the monitor wafer has a low resistance, and hence the resistance cannot be guaranteed in some cases. In such a case, epitaxial growth may be carried out with respect to one monitor wafer alone to measure a thickness, and a resistance of an epitaxial wafer manufactured by using the wafer as a product may be directly guaranteed.

After performing epitaxial growth with respect to the monitor wafer having the CVD film formed on the back surface thereof, epitaxial growth is carried out with respect to a wafer as a dummy (dummy wafer), or a vapor phase growth apparatus is activated under conditions for performing epitaxial growth without using a wafer (FIG. 1(B)).
As explained above, when the monitor wafer having the CVD film formed on the back surface thereof is used to perform epitaxial growth, auto-doping can be avoided, and guaranteeing a resistance or measuring a thickness of the epitaxial layer can be preferably carried out, but moisture discharged from the CVD film remains in a chamber, and heavy-metal contamination occurs in the wafer that is performed epitaxial growth next. Thus, epitaxial growth is performed with respect to the dummy wafer before performing epitaxial growth with respect to the wafer as a product. Alternatively, the vapor phase growth apparatus is activated under conditions for performing epitaxial growth without using a wafer, i.e., without putting a wafer in the chamber.
Although a silicon wafer having no CVD film must be used as the dummy wafer like the product wafer, it does not have to have completely the same properties as the product wafer.

When the dummy wafer is performed epitaxial growth or the vapor phase growth apparatus is activated under conditions for performing epitaxial growth without using a wafer after performing epitaxial growth with respect to the monitor wafer as explained above and before carrying out epitaxial growth with respect to the product wafer, the heavy-metal contamination caused due to the moisture discharged from the CVD film of the monitor wafer is absorbed in the epitaxial layer grown on the dummy wafer or a silicon layer grown on, e.g., a susceptor.

Here, the number of times of performing epitaxial growth is not restricted in particular, but when epitaxial growth with respect to the dummy wafer or activation of the vapor phase growth apparatus is repeatedly carried out, a cost is increased and productivity is reduced. On the other hand, it was revealed from an examination conducted by the present inventors that performing, e.g., epitaxial growth with respect to the dummy wafer twice enables absorbing substantially all of the heavy-metal contamination caused due to the moisture remaining in the chamber. Therefore, it is good enough to perform epitaxial growth with respect to the dummy wafer or activation of the vapor phase growth apparatus twice or below, i.e., perform epitaxial growth with respect to one or two dummy wafers when using such a single-wafer processing type apparatus as shown in FIG. 5 to perform epitaxial growth with respect to the dummy wafers.

After the dummy wafer is performed epitaxial growth, epitaxial growth is performed with respect to the wafer as a product to manufacture an epitaxial wafer (FIG. 1 (C)) .
Since an N-type wafer having a high resistance, i.e., a low dopant concentration is used as the wafer as a product; the CVD film for avoiding auto-doping is not required. Performing epitaxial growth with respect to such a wafer as a product enables manufacturing the high-quality epitaxial wafer that is preferable for an imaging device, e.g., a CCD or a CMOS image sensor without undergoing the heavy-metal contamination caused due to the moisture from the CVD film of the monitor wafer.

### <Second Embodiment>

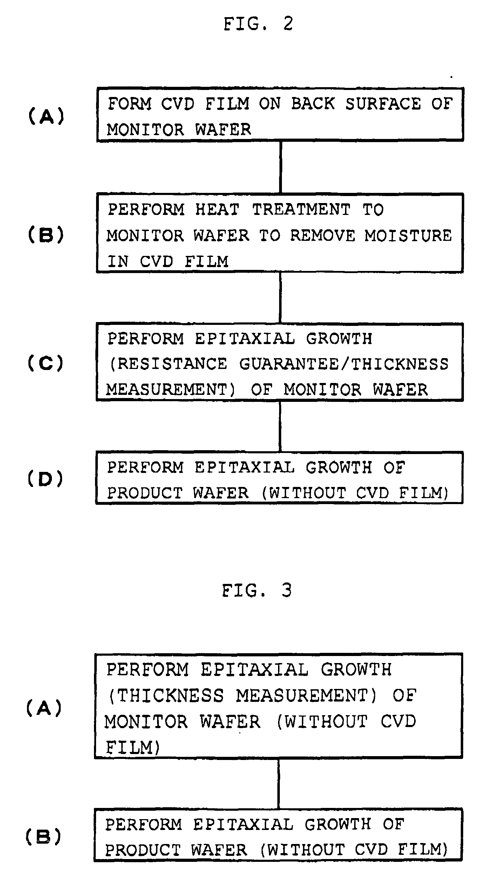

FIG. 2 is a flowchart showing a second embodiment of the method for manufacturing an epitaxial wafer according to the present invention.
First, in order to prepare a wafer for monitoring that is used to guarantee a resistance and/or measure a thickness of an epitaxial layer, a CVD film is formed on a back surface of an N-type low-resistance silicon wafer (FIG. 2(A)). It is desirable to use a silicon oxide film, a silicon nitride film, or a polysilicon film as this CVD film like the first embodiment.

Then, a heat treatment is performed with respect to the monitor wafer having the CVD film formed on the back surface thereof to remove moisture in the CVD film (FIG. 2(B)). Although heat treatment conditions are not restricted in particular, when a heat treatment is performed in, e.g., an N₂/O₂ mixed atmosphere having an oxygen concentration of 3% at 700 to 900°C for 30 seconds to 10 minutes, the moisture in the CVD film can be assuredly removed, and the monitor wafer or the CVD film is not adversely affected.

Then, in a vapor phase growth apparatus used for manufacture of the epitaxial wafer, the thus prepared wafer for monitoring is performed epitaxial growth to guarantee a resistance and/or measure a thickness of an epitaxial layer (FIG. 2(C)).
Although the CVD film is formed on the back surface of the monitor wafer, since the moisture in the CVD film has been removed by the previously performed heat treatment, the moisture is rarely discharged from the CVD film during epitaxial growth. Therefore, after the monitor wafer is performed epitaxial growth, the moisture from the CVD film does not remain in a chamber, and heavy-metal contamination is not provoked during the next epitaxial growth.

After performing epitaxial growth with respect to the monitor wafer, epitaxial growth is performed with respect to a wafer as a product to manufacture an epitaxial wafer (FIG. 2(D)).
As the wafer as a product, an N-type silicon wafer having a high resistance and having no CVD film for avoiding auto-doping formed thereon is used like the first embodiment. When performing epitaxial growth with respect to such a product wafer, since the moisture from the CVD film of the monitor wafer is rarely present in the chamber, the product wafer does not undergo heavy-metal contamination, and the high-quality epitaxial wafer that is preferable for an imaging device, e.g., a CCD or a CMOS image sensor can be manufactured.

### <Third Embodiment>

In a vapor phase growth apparatus used to manufacture an epitaxial wafer, epitaxial growth is performed with respect to a wafer having no CVD film formed on a back surface thereof as a wafer for monitoring which is used to measure a thickness of an epitaxial layer (FIG. 3(A)).
Here, when an N-type silicon wafer having a low resistance and having no CVD film formed on a back surface thereof as the monitoring wafer to perform epitaxial growth, a dopant in the wafer is taken into an epitaxial growth layer due to auto-doping, and an electrical difference between the wafer and the epitaxial layer is reduced. In this case, even though a thickness of the epitaxial layer can be measured, guaranteeing a resistance is difficult. Therefore, in this example, it is good enough to carry out epitaxial growth with respect to the monitor wafer to measure a thickness of the epitaxial layer, and perform the same with respect to a product wafer to guarantee a resistance.

After performing epitaxial growth with respect to the monitor wafer as explained above, a wafer as a product is performed epitaxial growth to manufacture an epitaxial wafer (FIG. 3 (B)) .
As explained above, since a wafer having no CVD film is used as the monitor wafer, even if the wafer as a product is performed epitaxial growth after performing epitaxial growth with respect to the monitor wafer, heavy-metal contamination due to moisture in the CVD film does not occur, thereby manufacturing a high-quality epitaxial wafer that is preferable for an imaging device, e.g., a CCD or a CMOS image sensor.

### <Fourth Embodiment>

For example, when using such a single-wafer processing type vapor phase growth apparatus as shown in FIG. 5 to manufacture each epitaxial wafer, although epitaxial wafers are continuously manufactured one by one, heating using, e.g., a halogen lamp is not stopped in accordance with each wafer, but heating is continuously carried out. On the other hand, when stopping a manufacturing line or when performing maintenance of the apparatus, heating is stopped to interrupt manufacture of the epitaxial wafer.
Further, when restarting manufacture of the epitaxial wafer, although a carrier gas is supplied and heating is again performed by using the halogen lamp, putting a product wafer immediately after restart to manufacture the epitaxial wafer readily provokes heavy-metal contamination due to moisture agglomerated and remaining in a chamber.

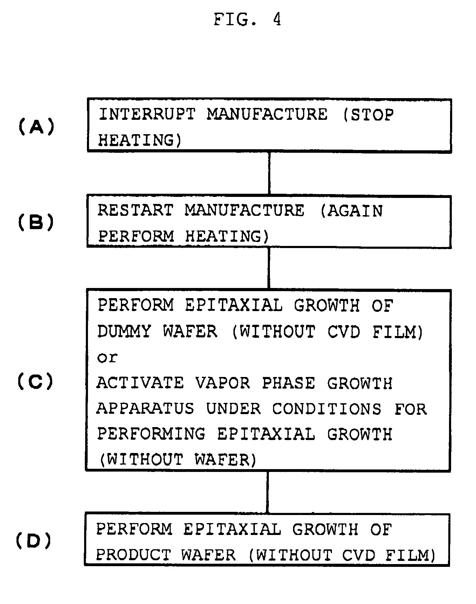

Thus, after heating is stopped to interrupt manufacture of the epitaxial wafer (FIG. 4(A)), when heating is again performed to restart manufacture (FIG. 4(B)), a wafer as a dummy is performed epitaxial growth or a vapor phase growth apparatus is activated under conditions for performing epitaxial growth without using a wafer (FIG. 4(C)).
Here, although a silicon wafer having no CVD film is used as the dummy wafer like the product wafer, this silicon wafer does not have to have completely the same properties as the product wafer, and an N-type low-resistance silicon wafer may be used, for example. As explained above, at the time of restarting manufacture of the epitaxial wafer, when the dummy wafer is perform epitaxial growth or the vapor phase growth apparatus is activated under conditions for performing epitaxial growth without using a wafer before performing epitaxial growth with respect to the product wafer, heavy-metal contamination due to the moisture remaining in the chamber can be absorbed into an epitaxial layer (silicon layer) grown on, e.g., the dummy wafer.

Here, the number of times of performing epitaxial growth with respect to the dummy wafer or the number of times of activating the vapor phase growth apparatus under conditions for performing epitaxial growth without using the wafer is the same as that in the first embodiment in order to assuredly remove the heavy-metal contamination due to the moisture remaining in the chamber and suppress an increase in a cost and a reduction in productivity. That is, when the single-wafer type apparatus is used to perform epitaxial growth with respect to the dummy wafer, it is preferable to carry out epitaxial growth with respect to two dummy wafers at most.

After the dummy wafer is performed, e.g., epitaxial growth as explained above, epitaxial growth is carried out with respect to the wafer as a product to manufacture an epitaxial wafer (FIG. 4(D)). When restarting manufacture, since the heavy-metal contamination caused due to the moisture remaining in the chamber is removed or reduced by the epitaxial layer (silicon layer) grown on, e.g., the dummy layer, the heavy-metal contamination due to the remaining moisture does not occur during epitaxial growth of the product wafer, thereby manufacturing the high-quality epitaxial wafer that is preferable for an imaging device, e.g., a CCD or a CMOS image sensor.

As explained above, according to the present invention, the heavy-metal contamination due to the moisture from the CVD film of the monitor wafer or the moisture agglomerated in the chamber after stopping heating is absorbed into, e.g., the epitaxial layer grown on, e.g., the dummy wafer, and then the wafer as a product is performed epitaxial growth. Therefore, the heavy-metal contamination with respect to the wafer as a product can be effectively avoided without providing a special additional facility that removes the moisture, thereby manufacturing the high-quality epitaxial wafer that is preferable for an imaging device, e.g., a CCD or a CMOS image sensor.

Examples according to the present invention will now be explained hereinafter.

### (Example 1)

Such a single-wafer processing type vapor phase epitaxial growth apparatus as shown in FIG. 5 was used, and heating using a lamp was stopped after a steady operation to interrupt manufacture of an epitaxial wafer.
After four hours from interruption of manufacture, heating using the lamp was again commenced to restart manufacture of the epitaxial wafer.
Epitaxial growth conditions are as follows.
A conductivity type and a resistivity of a material substrate (silicon wafer): N type, 10 Ωcm
A thickness of an epitaxial layer: 6 µm
A conductivity type and a resistivity of the epitaxial layer: N type, 10 Ωcm
A reaction temperature: 1100 to 1150°C
A pressure: ordinary pressure

A relationship between the number of wafers and a surface layer PL (photoluminescence) intensity after restarting manufacture of the epitaxial wafer was checked. It is to be noted that a measurement wavelength was set to 1 µm or below and an output was set to 15 mW in measurement of the surface layer PL intensity.
Furthermore, as a comparison, a surface layer PL intensity of an epitaxial layer manufactured by a continuous operation without interrupting manufacture of the epitaxial wafer was checked.
It is to be noted that, when the surface layer PL intensity is low, this means that a lifetime of a carrier is short and a surface layer has many defects.

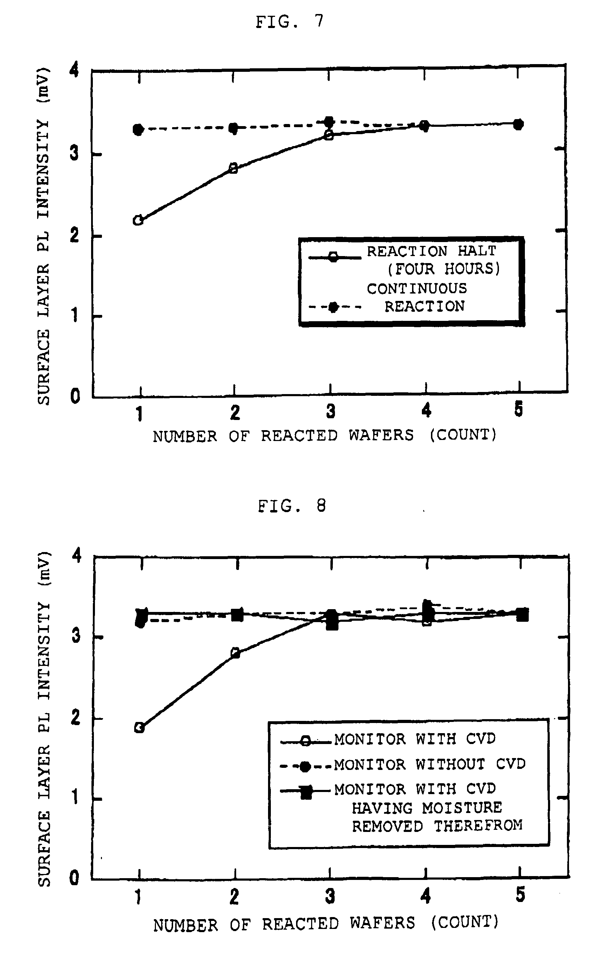

FIG. 7 shows a result.

As apparent from FIG. 7, it can be understood that first and second epitaxial wafers obtained after restarting manufacture of the epitaxial wafer have a low surface layer PL intensity and many surface layer defects. Therefore, it can be understood that, when heating of the vapor phase growth apparatus is stopped to interrupt manufacture of the epitaxial wafer, performing epitaxial growth using the dummy wafer with respect to the first wafer and, preferably, the second wafer enables greatly reducing the surface layer defects in subsequent product wafers, thereby manufacturing the high-quality epitaxial wafer.

### (Example 2)

Such a single-wafer processing type epi-growth apparatus as shown in FIG. 5 was used, a monitor wafer having a CVD film (silicon oxide film) formed on a back surface thereof was performed epitaxial growth, and then epitaxial growth was continuously performed with respect to five silicon wafers (having no CVD film) .
Subsequently, after performing epitaxial growth with respect to a monitor wafer having no CVD film on the back surface thereof, epitaxial growth was continuously carried out with respect to five silicon wafers (having no CVD film) .
Furthermore, after forming the CVD film (silicon oxide film) on the back surface, epitaxial growth was performed with respect to the monitor wafer subjected to a heat treatment at 800°C for one minute to remove moisture in the CVD film. Thereafter, epitaxial growth was continuously carried out with respect to five silicon wafers (having no CVD film).

Epitaxial growth conditions are as follows.
A conductivity type and a resistivity of a material substrate (silicon wafer): N type, 10 Ωcm
A thickness of an epitaxial layer: 6 µm
A conductivity type and a resistivity of the epitaxial layer: N type, 10 Ωcm
A reaction temperature: 1100 to 1150°C
A pressure: ordinary pressure

A relationship between each wafer performed epitaxial growth and a surface layer PL (photoluminescence) intensity was checked, and FIG. 8 shows its result.
As apparent from FIG. 8, it can be understood that, when each wafer having the CVD film formed on the back surface thereof was performed epitaxial growth and then epitaxial growth was performed with respect to each wafer having no CVD film, first and second wafers have a low surface layer PL intensity and many surface layer defects.
On the other hand, it can be comprehended that, when the monitor wafer having no CVD film on the back surface thereof and the monitor wafer in which the moisture has been removed from the CVD film on the back surface were used to carry out epitaxial growth, first and second wafers subsequently performed epitaxial growth have a high surface layer PL intensity and a low surface layer defect density.

It is to be noted that the present invention is not restricted to the foregoing examples. The foregoing examples are just exemplifications, and any inventions having substantially the same structures as technical concepts explained in claims according to the present invention and demonstrating the same functions and effects are included in the technical scope of the present invention.

For example, although the example where the N-type low-resistance silicon wafer is used as the monitor and then the high-resistance wafer is used to manufacture the epitaxial wafer has been explained in the foregoing embodiments, the wafer that can be a material is not restricted thereto, the moisture in the CVD film or the moisture at the time of stopping heating likewise becomes a problem when, e.g., a P-type silicon wafer is used to manufacture an epitaxial wafer, and the present invention can be applied thereto. It is needless to say that a device to be fabricated is not restricted to the CCD or the CMOS image sensor.
Moreover, although the example where the single-wafer processing type vapor phase growth apparatus shown in FIGS. 5 and 6 is used to manufacture the epitaxial wafer has been explained, the vapor phase growth apparatus which can be used in the present invention is not restricted thereto, and the present invention can adopt a single-wafer processing type vapor phase growth apparatus which is of any other type as well as a batch type vapor phase growth apparatus. That is because a problem of occurrence of heavy-metal contamination due to moisture is still present in such cases.

## Claims

1. A method of manufacturing an epitaxial wafer, comprising: performing epitaxial growth with respect to a wafer having a CVD film formed on a back surface thereof as a wafer for monitoring that is used to guarantee a resistance and/or measure a thickness of an epitaxial layer in a vapor phase growth apparatus; performing epitaxial growth with respect to a wafer as a dummy or activating the vapor phase growth apparatus under conditions for performing epitaxial growth without using a wafer; and then carrying out epitaxial growth with respect to a wafer as a product to manufacture the epitaxial wafer.

2. A method of manufacturing an epitaxial wafer, comprising: preparing a wafer in which a CVD film is formed on a back surface thereof and moisture is then removed from the CVD film by subjecting to a heat treatment as a wafer for monitoring that is used to guarantee a resistance and/or measure a thickness of an epitaxial layer; performing epitaxial growth with respect to the prepared wafer for monitoring in a vapor phase growth apparatus; and then carrying out epitaxial growth with respect to a wafer as a product to manufacture the epitaxial wafer.

3. The method of manufacturing an epitaxial wafer according to claim 1 or 2, wherein a silicon wafer having a silicon oxide film, a silicon nitride film, or a polysilicon film as the CVD film of the wafer for monitoring is used.

4. A method of manufacturing an epitaxial wafer, comprising: performing epitaxial growth with respect to a wafer having no CVD film formed on a back surface thereof as a wafer for monitoring that is used to measure a thickness of an epitaxial layer in a vapor phase growth apparatus; and then carrying out epitaxial growth with respect to a wafer as a product to manufacture the epitaxial wafer.

5. A method of manufacturing an epitaxial wafer, comprising: when stopping heating to interrupt manufacture of the epitaxial wafer and then again subjecting to heating to restart manufacture in a vapor phase growth apparatus: performing epitaxial growth with respect to a wafer as a dummy or activating the vapor phase growth apparatus under conditions for performing epitaxial growth without using a wafer; and then carrying out epitaxial growth with respect to a wafer as a product to manufacture the epitaxial wafer.

6. The method of manufacturing an epitaxial wafer according to any one of claims 1 to 5, wherein a single-wafer processing type is used as the vapor phase growth apparatus.

7. The method of manufacturing an epitaxial wafer according to any one of claims 1 to 6, wherein, when performing epitaxial growth with respect to the wafer as a dummy or the wafer for monitoring or when activating the vapor phase growth apparatus under conditions for performing epitaxial growth without using a wafer, the number of times of performing each of these operations is two or below.

8. The method of manufacturing an epitaxial wafer according to any one of claims 1 to 7, wherein the epitaxial wafer as a product is used for a CCD or a CMOS image sensor.

9. An epitaxial wafer manufactured by the method according to any one of claims 1 to 8.
